# EUROPEAN PATENT SPECIFICATION

(11) **EP 2 078 985 B1**
(45) Date of publication and mention of the grant of the patent: **02.07.2014**
(21) Application number: 09000225.4
(22) Date of filing: 09.01.2009
(51) Int. Cl.: G03F 7/30

(54) **Method for developing lithographic printing plate**
Verfahren zur Entwicklung einer Lithographiedruckplatte
Procédé de développement de plaque d'impression lithographique

(30) Priority: 09.01.2008 JP 2008002435
(43) Date of publication of application: 15.07.2009
(73) Proprietor: FUJIFILM Corporation, Tokyo 106-0031 (JP)
(72) Inventor: Ohishi, Chikashi, Shizouka (JP)
(74) Representative: HOFFMANN EITLE

(56) References cited:
- EP-A- 1 696 275
- EP-A- 1 973 000
- JP-A- 2006 251 368

## Description

### FIELD OF THE INVENTION

This invention relates to a method for developing a lithographic printing plate for producing a lithographic printing plate. More specifically, it relates to a method for developing a lithographic printing plate in the case of using a developing apparatus which has a preheating section for preheating the lithographic printing plate having been imagewise exposed and a development section.

### BACKGROUND OF THE INVENTION

In order to produce a lithographic printing plate to be used in ultra high-speed printing, it has been a common practice to use a lithographic printing plate precursor (PS plate) comprising a hydrophilic support having provided thereon an oleophilic photosensitive resin layer (image-recording layer) . Ordinarily, the lithographic printing plate is obtained by conducting plate-making according to a method which comprises exposing the lithographic printing plate precursor through an original, for example, a lith film, and then while leaving the image area of the image-recording layer, removing the image-recording layer in other unnecessary areas by dissolving with an alkaline developer or an organic solvent thereby revealing the hydrophilic surface of support and forming the non-image area (see, for example, JP-A-10-18667E) .

EP-A-1 973 000, which represents prior art under Article 54(3) EPC, discloses an automatic developing apparatus comprising a pre-heating zone and a development zone. The development tank is connected to lines for circulating the developer in the tank.

EP-A-1 696 275 teaches an automatic developing machine comprising a pre-heating unit upstream of a developing unit. The developing unit contains a developing tank connected to a pipe for circulating developer in the tank.

### SUMMARY OF THE INVENTION

In the method for developing a lithographic printing plate as disclosed in JP-A-10- 286678, when the lithographic printing plate is submerged in the developer in the development section, a portion of the developer contained in the treating tank first coming into contact with the lithographic printing plate shows an increase in temperature due to the lithographic printing plate which has an elevated temperature. The developer in the part surrounded by the first rollers (rollers provided at uppermost stream side) provided in the developer in the treating tank and the guide board provided in the developer for guiding to the first rollers is liable to be affected by the lithographic printing plate which has an elevated temperature. Such an increase in the developer temperature causes an uneven temperature distribution from the front end of the lithographic printing plate to the back end thereof and, in its turn, results in a difference in development characteristics to thereby undesirably affect the treated image.

An object of the invention that has been made under the above-described circumstances is to provide a method for developing a lithographic printing plate whereby the lithographic printing plate can be uniformly treated.

The above object of the invention can be solved by the following method.
(1) A method for developing a lithographic printing plate comprising treating a lithographic printing plate (s), while conveying the plate, at least in a pre-heating zone (20) and a development zone (40) located downstream thereof in a, developing apparatus (1) ;
   wherein :
   the development zone comprises a treating tank (42), which contains a developer (D), and a developer-circulating unit (76, 146), the developer-circulating unit being located in the neighbourhood of the plate inlet of the treating tank, which is a region located above a guide board (48) between the plate inlet and first rollers (52) located in the developer along the plate-conveyance route, the guide board being located in the developer between the plate inlet and the first rollers;
   developer in the neighbourhood of the plate inlet is conveyed and circulated in the treating tank by the developer-circulating unit; and
   the developer-circulating unit is one of the following:
      (i) a tubular spray pipe (142) extending along the axial direction of the first rollers, which are conveying rollers, and having multiple ports along its length which discharge fresh developer in the radial direction of the first rollers towards developer pooled at the upstream side of the first rollers;
      (ii) a rotating blade member (146) which extends along the axial direction of the first rollers, which are conveying rollers, and causes developer in the neighbourhood of the plate inlet to flow and be replaced by developer under circulation in the treating tank.

Owing to this constitution, when the lithographic printing plate having the elevated temperature is guided into the treating tank, the temperature increase in the developer in the neighborhood of the lithographic printing plate inlet is prevented, which enables uniform treatment without causing a difference in the development characteristics of the lithographic printing plate.

Fresh developer is supplied to the neighborhood of the lithographic printing plate inlet by the tubular spray pipe and the developer in the treating tank is forcibly transferred. Thus, it is possible to prevent an increase in the developer temperature by employing a simple structure such as a pump without resorting to use a complicated structure as the developer-circulating unit.

Developed in the neighborhood of the lithographic printing plate inlet is made to flow by the rotating blade member and is forcibly replaced by developer in the treating tank under circulation. Thus, it is possible to prevent an increase in the developer temperature by employing a simple structure without resorting to use a complicated structure as the developer-circulating unit.
(2) The method for developing a lithographic printing plate as described in (1) above,
   wherein the rotating blade member generates a flow by rotation and vibration.
   According to the method for developing a lithographic printing plate having the constitution as described above,
   an increase in the temperature can be further prevented
   by rotating and vibrating a rotating blade that is employed as the flow-generating unit.
(3) The method for developing a lithographic printing plate as described in (1) or (2) above, wherein at least the development zone has an enclosed structure.
   According to the method for developing a lithographic printing plate having the constitution as described above,
   since the development zone has an enclosed structure, the development zone can be prevented from the invasion of outside light and the atmosphere within the development section can be maintained at an appropriate temperature and humidity, which makes it possible to perform the development without affected by outside light, temperature or humidity. The humidity can be controlled by regulating the moisture evaporation from the developer and thus stable development can be performed.
(6) The method for developing a lithographic printing plate as described in any one of (1) to (5) above, wherein the developer contains 3 to 20% by mass of a surfactant and has a pH value of 4 to 9.5.
   In the case of using, in particular, such a developer as described above in a commonly employed automatic developing machine, the developer can be hardly stirred due to an increase in viscosity and shows a solution temperature distribution therein, which results in unevenness in development. In contrast, the above method is highly effective.
(7) The method for developing a lithographic printing plate as described in (6) above, wherein the developer contains 1 to 10% by mass of a water-soluble resin as a component thereof.

In the case of using, in particular, such a developer as described above in a commonly employed automatic developing machine, the developer can be hardly stirred due to an increase in viscosity and shows a solution temperature distribution therein. In contrast, the method of the invention is highly effective.

According to the method for developing a lithographic printing plate of the invention, treatment of the lithographic printing plate can be uniformized.

### BRIEF DESCRIPTION OF THE DRAWINGS

Fig. 1 is a diagram which schematically shows the constitution of a developing apparatus for a lithographic printing plate to which a reference method for developing a lithographic printing plate is applied.
Fig. 2 is an enlarged view of the development zone of the apparatus of Fig. 1.
Fig. 3 is an enlarged perspective view of the major part of Fig. 2.
Fig. 4 is an enlarged perspective view of the major part of a developing apparatus for lithographic printing plate to which the method for developing a lithographic printing plate according to the first embodiment of the invention is applied.
Fig. 5 is an enlarged perspective view of the major part of a developing apparatus for lithographic printing plate to which the method for developing a lithographic printing plate according to the second embodiment of the invention is applied.

### [Description of the Reference Numericals and Signs]

- 1: Developing apparatus for lithographic printing plate
- 2: Developing apparatus for lithographic printing plate
- 3: Developing apparatus for lithographic printing plate
- 20: Heating section (preheating zone)
- 40: Development section (development zone)
- 76: Spray pipe (developer-circulating unit)
- 142: Spray pipe (developer-circulating unit)
- 146: Rotating blade member (rotating blade) (flow-generating unit)
- D: Developer
- S: Lithographic printing plate

### DETAILED DESCRIPTION OF THE INVENTION

Next, a plural number of modes for carrying out the method for developing a lithographic printing plate of the invention will be described in greater detail by referring to drawings.

### (Reference embodiment)

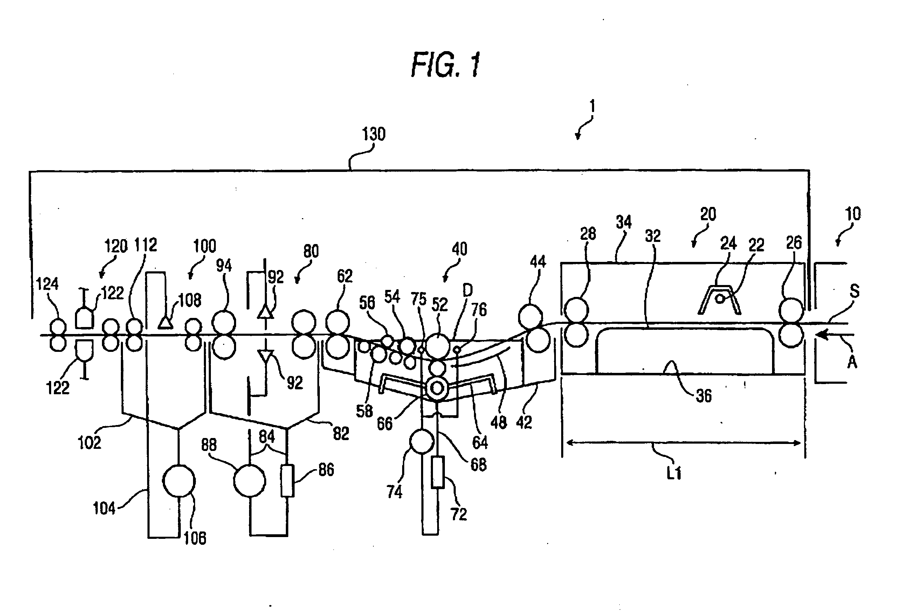

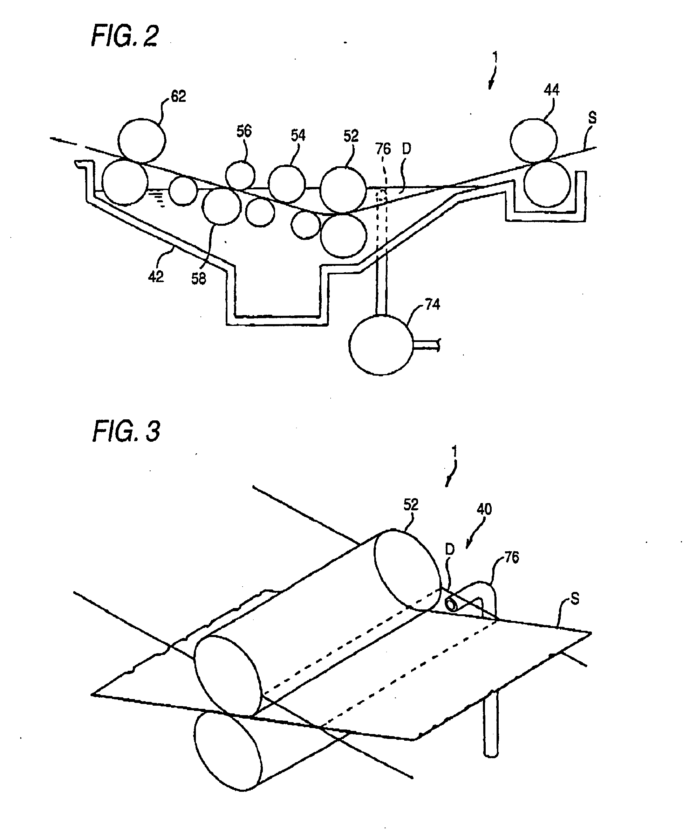

Figs. 1 to 3 illustrate the reference method for developing a lithographic printing plate. Fig. 1 is a diagram schematically showing the constitution of a developing apparatus for lithographic printing plate to which the reference method is applied. Fig. 2 is an enlarged view of the development zone of the apparatus of Fig. 1. Fig. 3 is an enlarged perspective view of the major part of Fig. 2.

As Figs. 1 and 2 show, the developing apparatus 1 comprises, toward the downstream side along the conveying direction A of a lithographic printing plate S, an exposure section 10, a heating section (preheating zone) 20, a development section (development zone) 40, a water-washing section 80, a gum solution-coating section 90 and a drying section 120, wherein the heating section 20, the development section 40, the water-washing section 80, the gum solution-coating section 90 and the drying section 120 are located in an enclosed treating chamber 130.

In the exposure section 10, the lithographic printing plate S is exposed.

The heating section 20 comprises multiple heating units 22 for heating the lithographic printing plate S, shade-shaped reflecting plates 24 covering the heating units 22, upstream side conveying rollers 26 and downstream side conveying rollers 28 pressing the lithographic printing plate S upward and downward and conveying the same, and a support 32 supporting upward the lithographic printing plate S under conveyance that are located in a box-shaped case 34. The support 32 is made up of a member substantially being in linear contact with the lithographic printing plate S, for example, a wire. In this constitution, the position of the support face of lithographic printing plate S supported by the supporter 32 is designed so that the face apart a predetermined distance from the case bottom 36 facing the heating units 22.

With respect to the size of the heating section 20 and the intervals among the individual members, the interval L1 between the conveying rollers 26 and 28 is about 320 mm, while the support 32 is made of stainless steel and has a wire diameter of about 4 mm and a distance of 10 mm or longer. The support 32 may be made of any material so long as being tolerant to heating at about 200°C. For example, use can be made of a metal material such as steel or aluminum. Further, the metal material may be coated with a fluororesin to prevent marks which might be formed on the back face of the lithographic printing plate S by sliding. Examples of the resin material include an aramid resin, bakelite and so on.

As the heating units 22, far-infrared ceramic heaters are employed in this embodiment to radiate far-infrared rays. Alternatively, use may be made of halogen lamp heaters surface-coated with a black ceramic coating as the heaters. The conveyance speed of the lithographic printing plate S is set to a constant level of, for example, 1140 mm/min while the heater output is set to a maximum output of 600 W and a standard voltage of 200 V.

The development section 40 has inlet conveying rollers 44, a guide board 48, a pair of conveying rollers 52, brush rollers normally rotating with respect to the conveying direction, guide rollers 56 and 58, a pair of squeeze rollers 62 and so on that are arranged from the upstream side of the treating tank 42 containing the developer D. A heater 66 having a cooling water-flow pipe 64, which is provided in the treating tank 42, is connected to a filter 72 and a pump 74 via a pipe 68. In the neighborhood of the lithographic printing plate inlet located in the upstream side of the conveying roller 52 provided in the developer D, a spray pipe (a developer-circulating unit) 76 connected to the pump 74 is located.

In the development section 40, the lithographic printing plate S having been conveyed from the heating section 20 is submerged in the developer by the inlet conveying rollers 44. Next, the lithographic printing plate S is transferred along the guide board 48 in the developer. Then, it is held between a pair of conveying rollers 52 and brought into contact in the development face with the brush rollers 54. Next, the lithographic printing plate S is brought above the developer by the guide rollers 56 and 58, held between a pair of squeeze rollers 62, and then transferred into the water-washing section 80.

In this step, the temperature of the developer D is controlled by heating with the heater 66 and cooling with the cooling water-flow pipe 64. Further, the developer is optionally supplied from a suppliance pump (not shown in the drawing) and the excessive developer D is discharged by overflowing. Furthermore, water is supplied from a water-suppliance pump for making up for moisture evaporation. Stains in the developer D in the pipe 68 are removed by the filter 72, while the developer D is circulated by the pump 74 through the spray pipes 75 and 76.

When the lithographic printing plate S having an elevated temperature is transferred into the treating tank 42, the developer D at a predetermined temperature (i.e., non-heated) is provided from the spray pipe 76 through the pump 74 and discharged to the upstream of a pair of conveying rollers 52 located in the downstream of the guide board 48. Thus, the temperature of developer D in the neighborhood of the lithographic printing plate inlet is not elevated by the heat of the lithographic printing plate S. The "neighborhood of the lithographic printing plate inlet" means a part surrounded by a pair of conveying rollers 52 that is located in the developer contained in the treating tank 42 and appears first along the conveyance route of the lithographic printing plate S and the guide board 48 located from the inlet of the treating tank to the conveying rollers 52. The flow rate of the developer circulated through the spray pipe 76 may be at any level so long as the developer is prevented from retention. Namely, a flow rate of 0.1 to 5 1/min may suffice, though it depends on the size of an automatic developing machine.

The water-washing section 80 comprises a spray pathway having a water-washing tank 82 pooling washing water such as tap water, a filter 86 removing stains from a pipe 84 and the washing water, a pump 88 lifting the washing water and spray nozzles 92, squeeze rollers 94 for conveying the lithographic printing plate S and removing the washing water, and so on. In this section, the developer D sticking to the lithographic printing plate S is washed off.

The spray nozzles 92 are provided so as to spray the washing water onto both side faces of the lithographic printing plate S under conveyance. The lithographic printing plate S, which has been thus water-washed in both side faces, is then conveyed to the subsequent gum solution-coating section 100. Suppliance pathways for supplying tap water or the like to the water-washing tank 82 are provided to the parts other than the spray pathway.

The gum solution-coating section 100 comprises a spray pathway having a gum solution tank 102 pooling a gum solution, a pipe 104, a pump 106 sucking and pressurizing the gum solution and spray nozzles 108, conveying rollers 112 for conveying the lithographic printing plate S, and so on. In this section, the gum solution for protecting the image formation face of the lithographic printing plate S is coated.

In the gum solution-coating section 100, the gum solution is sprayed from the spray nozzles 10 to the image formation face while the lithographic printing plate S is conveyed. The lithographic printing plate S thus coated with the gum solution is conveyed by the conveying rollers 112 to the subsequent drying section 120. In the gum solution-coating section 100, suppliance pathways for supplying the gum solution to the gum solution tank 102 are separately provided too and a filter for removing stains from the gum solution is also provided in the spray pathway. The water-washing section 80 and the gum solution-coating section 100 can be omitted, depending on the formulations of the lithographic printing plate and the developer D. In such a case, the lithographic printing plate may be immediately conveyed to the drying section after the completion of the development.

The drying section 120 comprises hot air nozzles 122 blowing a hot air stream to both side faces of the lithographic printing plate S, conveying rollers 124 and so on. By blowing a hot air stream from the hot air nozzles 122, the moisture and gum solution sticking to the lithographic printing plate S are completely removed to give a finished printing plate.

As Fig. 3 shows, the spray pipe 76, which is a tubular member produced merely by bending, is provided laterally in the upstream side of a pair of conveying rollers 52. A fresh developer D fed from the pump 74 is discharged toward the developer D pooled in the upstream side of the conveying rollers 52 along the axis direction of the conveying rollers 52. Thus, no complicated structure is required and the production can be performed at a low cost.

As discussed above, according to the reference method for developing a lithographic printing plate, the developer D at a predetermined temperature (i.e., non-heated) is discharged from the spray pipe 76, which located in the neighborhood of the lithographic printing plate inlet of the treating tank 42 in the development zone, to the upstream of a pair of conveying rollers 52 located in the downstream of the guide board 48. Thus, the developer D is transferred and circulated within the treating tank 42. Owing to this constitution, when the lithographic printing plate S having the elevated temperature is guided into the treating tank 42, the temperature increase in the developer D in the neighborhood of the lithographic printing plate inlet is prevented, which enables uniform treatment without causing a difference in the development characteristics of the lithographic printing plate S.

According to the reference method for developing a lithographic printing plate, a fresh developer D is supplied to the neighborhood of the lithographic printing plate inlet by the spray pipe 76 and the developer D in the treating tank 42 is forcibly transferred. Thus, it is possible to prevent an increase in the temperature of the developer D by employing such a simple structure as using a pump 74 in common without resorting to use a complicated structure.

According to the reference method for developing a lithographic printing plate, since the development section 40 is located in a treating chamber 130 having an enclosed structure, the development section 40 can be prevented from the invasion of outside light and the atmosphere within the development section 40 can be maintained at an appropriate temperature and humidity, which makes it possible to perform the development without affected by outside light, temperature or humidity.

### (First embodiment)

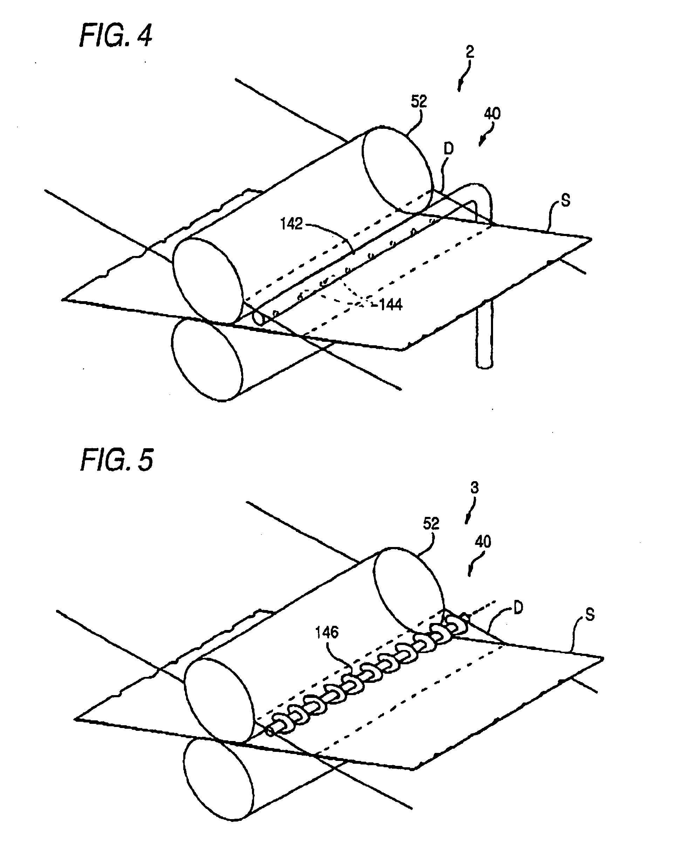

Next, the first embodiment according to the invention will be illustrated by referring to Fig. 4. Fig. 4 is an enlarged perspective view of the major part of a developing apparatus for lithographic printing plate to which the method for developing a lithographic printing plate according to the first embodiment of the invention is applied. In the following embodiments, the same symbols or corresponding symbols are assigned to constitutional elements overlapping those in the reference embodiment as described above or being functionally the same for the sake of simplification or skip.

As Fig. 4 shows, a spray pipe 142 is employed as a developer-circulating unit in the developing apparatus for lithographic printing plate according to the first embodiment.

The spray pipe 142, which is a tubular member produced by simply bending, extends in the axis direction of the conveying rollers 52 in the upstream side of the conveying rollers 52. It has multiple discharge ports 144 for discharging the fresh developer supplied from the pump 74 toward the developer D, which is pooled in the upstream side of the conveying rollers 52, in the radial direction of the conveying rollers 52. Other parts have the same structures as in the reference embodiment.

Although the method for developing a lithographic printing plate according to the first embodiment exerts the similar effects as the reference embodiment, the fresh developer D is discharged along the radial direction of the conveying rollers 52 in the first embodiment. Thus, a larger kinetic energy can be imparted to the developer D, which is pooled in the upstream side of the conveying rollers 52, and thus the developer D can be transferred more efficiently.

### [Second embodiment]

Next, the second embodiment according to the invention will be illustrated by referring to Fig. 5. Fig. 5 is an enlarged perspective view of the major part of a developing apparatus for lithographic printing plate to which the method for developing a lithographic printing plate according to the second embodiment of the invention is applied.

As Fig. 5 shows, a rotating blade member 146 is employed as a flow-generating unit serving as a developer-circulating unit in the developing apparatus for lithographic printing plate according to the second embodiment.

The rotating blade member 146, which is connected to a driving unit (not shown in the figure), is located in the upstream side of the conveying rollers 52 along the axis direction of the conveying rollers 52. When the driving unit is switched on, it rotates and makes the developer D, which is pooled in the upstream side of the conveying rollers 52, to flow, thereby forcibly replacing the developer D by another developer D in the treating tank 42 via circulation. The rotating blade member 146 may be connected to a vibrator unit as well as to the driving unit. In this case, the rotating blade rotates and vibrates per se so that the developer D can be more efficiently replaced via circulation.

Although the method for developing a lithographic printing plate according to the second embodiment exerts the similar effects as the reference embodiment, the rotating blade member 146 makes the developer D in the neighborhood of the lithographic printing plate inlet to flow and thus forcibly replace it by the developer D, which is pooled in the treating tank 42, via circulation. Thus, an increase in the developer temperature can be prevented by the simple structure without resorting to use a complicated structure. Moreover, the rotating blade member 146 can rotate and vibrate so that the developer D can be replaced and circulated more efficiently, which makes it possible to further prevent a temperature increase.

### <Developer particularly effective in the invention>

In the invention, a lithographic printing plate precursor is imagewise exposed and then the plate is preferably rubbed with a rubbing member in the presence of an aqueous solution of pH 2 to 10. Thus, any protective layer and the photosensitive layer in an unexposed area are removed so as to form an image on the surface of an aluminum plate support.

The aqueous solution to be used in the invention is an aqueous solution of pH 2 to 10. For example, water alone or an aqueous solution comprising water as the main component (containing 60% by mass or more of water) is preferred. In particular, an aqueous solution having a similar composition as publicly known dampening water, an aqueous solution containing a surfactant (anionic, nonionic, cationic, etc.) or an aqueous solution containing a water-soluble polymer compound is preferred. Among all, an aqueous solution containing both of a surfactant and water-soluble polymer compound is preferred. The pH value of the aqueous solution is preferably 3 to 9, more preferably 4 to 8.

Examples of the anionic surfactant usable in the invention include fatty acid salts, abietic acid salts, hydroxyalkanesulfonic acid salts, alkanesulfonic acid salts, dialkylsulfosuccinic ester salts, straight-chain alkylbenzenesulfonic acid salts, branched alkylbenzenesulfonic acid salts, alkylnaphthalenesulfonic acid salts, alkylphenoxypolyoxy ethylene propylsulfonic acid salts, polyoxyethylene alkylsulfophenyl ether salts, N-methyl-N-oleyltaurine sodium salt, N-alkylsulfosuccinic monoamide disodium salts, petroleum sulfonic acid salts, sulfated castor oil, sulfated beef tallow oil, sulfate ester slats of fatty acid alkyl ester, alkyl sulfate ester salts, polyoxyethylene alkyl ether sulfate ester salts, fatty acid monoglyceride sulfate ester salts, polyoxyethylene alkyl phenyl ether sulfate ester salts, polyoxyethylene styrylphenyl ether sulfate ester salts, alkyl phosphate ester salts, polyoxyethylene alkyl ether phosphate ester salts, polyoxyethylene alkyl phenyl ether phosphate ester salts, partial saponification products of styrene/maleic anhydride copolymer, partial saponification products of olefin/maleic anhydride copolymer and naphthalene sulfonate formalin condensates. Among them, it is particularly preferable to use dialkylsulfosuccinic ester salts, alkyl sulfate ester salts and alkylnaphthalenesulfonic acid salts.

The cationic acid usable in the invention is not particularly restricted. Namely, any publicly known ones may be used. Examples thereof include alkylamine salts, quaternary ammonium salts, polyoxyethylene alkyl amine salts and polyethylene polyamine derivatives.

Examples of the nonionic surfactant usable in the invention include polyethylene glycol type higher alcohol ethylene oxide adducts, alkylphenol ethylene oxide adducts, fatty acid ethylene oxide adducts, polyhydric alcohol fatty acid ester ethylene oxide adducts, higher alkylamine ethylene oxide adducts, fatty acid amide ethylene oxide adducts, fat ethylene oxide adducts, polypropylene glycol ethylene oxide adducts, dimethylsiloxane-ethylene oxide block copolymer, dimethylsiloxane-(propylene oxide-ethylene oxide) block copolymer, polyhydric alcohol type glycerol fatty acid esters, pentaerythritol fatty acid esters, sorbitol and sorbitan fatty acid esters, sucrose fatty acid esters, polyhydric alcohol alkyl ethers and alkanolamine fatty acid amides.

Either one of these nonionic surfactants or a mixture of two or more kinds of the same may be used. In the invention, sorbitol and/or sorbitan fatty acid ester ethylene oxide adducts, polypropylene glycol ethylene oxide adducts, dimethylsiloxane-ethylene oxide block copolymer, dimethylsiloxane-(propylene oxide-ethylene oxide) block copolymer and polyhydric alcohol fatty acid esters are more preferable.

From the viewpoint of the stable solubility or miscibility in water, it is preferable that the nonionic surfactant to be used in the invention has an HLB (hydrophile-lipophile balance) value of 6 or more, still preferably 8 or more. The amount of the nonionic surfactant contained in the aqueous solution is preferably 0.01 to 10% by weight, still preferably 0.01 to 5% by weight. Similarly, use can be made of acetylene glycol type and acetylene alcohol type oxyethylene adducts and fluorine-based and silicone-based surfactants.

The aqueous solution to be used in the invention may further contain an organic solvent. Examples of the organic solvent which can be contained include polar solvents such as aliphatic hydrocarbons (hexane, heptane, "ISOPER E, H, G" (manufactured by Esso Kagaku), gasoline, kerosene, etc.), aromatic hydrocarbons (toluene, xylene, etc.), halogenated hydrocarbons (methylene dichloride, ethylene dichloride, trichlene, monochlorobenzene, etc.), alcohols and esters.

In the case where the organic solvent as described above is insoluble in water, it can be solubilized in water by using a surfactant or the like before using. In the case where the aqueous solution contains an organic solvent, it is preferable from the viewpoints of safety and inflammability that the concentration of the solvent is less than 40% by weight.

The aqueous solution of the invention may contain a water-soluble polymer compound. Examples of the water-soluble polymer compound include soybean polysaccharide, modified starch, gum arabic, dextrin, cellulose derivatives (for example, carboxymethyl cellulose, carboxyethyl cellulose and methyl cellulose) and modified products thereof, pullulan, polyvinyl alcohol or derivatives thereof, polyvinyl pyrrolidone, polyacrylamide, acrylamide copolymers, vinyl methyl ether/maleic anhydride copolymers, vinyl acetate/maleic anhydride copolymers and styrene/maleic anhydride copolymers.

As the soybean polysaccharide, use can be made of publicly known ones. For example, as a commercial product, Soyafive (trade name, manufactured by Fuji Oil Co., Ltd.) is available and various grade products can be used. The soybean polysaccharide preferably usable herein is one having a viscosity in a range from 10 to 100 mPa/sec in a 10% by mass aqueous solution thereof.

As the modified starch, known modified starch can be used.
The modified starch can be prepared by, for example, a method which comprises digesting starch of corn, potato, tapioca, rice, wheat or the like with the use of an acid, an enzyme, etc. to give 5 to 30 glucose residues per molecule and then adding oxypropylene thereto in an alkali.

Two or more kinds of the water-soluble polymer compounds may be used in combination. The content of the water-soluble polymer compound in the developing solution is preferably from 0.1 to 20% by mass, more preferably from 0.5 to 10% by mass.

In addition to the components as cited above, the aqueous solution of the invention may contain an antiseptic agent, a chelating compound, a defoaming agent, an organic acid, an inorganic acid, an inorganic salt or the like.

Preferable examples of the antiseptic agent include phenol and its derivative, formalin, imidazole derivatives, sodium dehydroacetate, 4-isothiazolin-3-one derivatives, benzisotiazolin-3-one, benzotriazole derivatives, amidine guanidine derivatives, quaternary ammonium salts, pyridine derivatives, quinoline derivatives, guanidine derivatives, diazine, triazole derivatives, oxazole, oxazine derivatives and nitro bromo alcohols such as
2-bromo-2-nitropropane-1,3-diol,
1,1-dibromo-1-nitro-2-ethanol and
1,1-dibromo-1-nitro-2-propanol.

Examples of the chelating compound include ethylenediaminetetraacetic acid, potassium salt thereof, sodium salt thereof; diethylenetriaminepentaacetic acid, potassium salt thereof, sodium salt thereof; triethylenetetraminehexaacetic acid, potassium salt thereof, sodium salt thereof; hydroxyethylethylenediaminetriacetic acid, potassium salt thereof, sodium salt thereof, nitrilotriacetic acid, sodium salt thereof; 1-hydroxyethane-1,1-diphosphonic acid, potassium salt thereof, sodium salt thereof; organic phosphonic acids, for example, organic phosphonic acids such as aminotri (methylenephosphonic acid), potassium salt thereof, sodium salt thereof, and phophonoalkanetricarboxylic acids. A salt of an organic amine is also effectively used in place of the sodium salt or potassium salt in the chelating agents as described above.

As the defoaming agent, use can be made of, for example, a conventional silicone-based self-emulsifying type or emulsifying type defoaming agent, and a nonionic surfactant having HLB of 5 or less. The silicone defoaming agent is preferably used. Either an emulsifying dispersing type or a solubilizing type can be used.

Examples of the organic acid include citric acid, acetic acid, oxalic acid, malonic acid, salicylic acid, caprylic acid, tartaric acid, malic acid, lactic acid, levulinic acid, p-toluenesulfonic acid, xylenesulfonic acid, phytic acid and an organic phosphonic acid. The organic acid can also be used in the form of an alkali metal salt or an ammonium salt.

Examples of the inorganic acid and inorganic salt include phosphoric acid, methaphosphoric acid, ammonium primary phosphate, ammonium secondary phosphate, sodium primary phosphate, sodium secondary phosphate, potassium primary phosphate, potassium secondary phosphate, sodium tripolyphosphate, potassium pyrophosphate, sodium hexamethaphosphate, magnesium nitrate, sodium nitrate, potassium nitrate, ammonium nitrate, sodium sulfate, potassium sulfate, ammonium sulfate, sodium sulfite, ammonium sulfite, sodium hydrogen sulfate and nickel sulfate.

### [Lithographic printing plate precursor particularly effectively usable in the invention]

Next, a lithographic printing plate precursor to be used in the invention will be illustrated.

### <Photosensitive layer>

The lithographic printing plate precursor to be used in the plate-making method according to the invention has a negative-working photosensitive layer in which the photosensitive layer in an exposed area is hardened. Although the negative-working photosensitive layer is not particularly restricted, a radical polymerizable photosensitive layer containing a hydrophobic binder polymer, a polymerization initiator and a polymerizable compound is preferable from the viewpoints of developability and printing durability. Such a radical polymerizable photosensitive layer is dissolved in the developer and thus increases the viscosity of the developer, which makes it particularly effectively usable in an automatic developing machine of the invention.

Next, the components constituting the photosensitive layer will be described.

### (Hydrophobic binder polymer)

As the hydrophobic binder polymer usable in the photosensitive layer of the invention, a water-insoluble polymer is preferably employed. The hydrophobic binder polymer usable in the invention preferably contains substantially no acid group such as carboxyl group, sulfone group and phosphate group. The acid value (acid content per g of polymer, expressed by the chemical equivalent number) of the binder polymer is preferably 0.3 meq/g or less, more preferably 0.1 meq/g or less.

That is, the hydrophobic binder polymer usable in the invention is preferably insoluble in water or an aqueous solution of pH 10 or more, and the solubility of the hydrophobic binder polymer in water or an aqueous solution of pH 10 or more is preferably 0.5 % by mass or less, more preferably 0.1 % by mass or less. By using such a hydrophobic binder polymer, the film strength, water resistance and inking property of the photosensitive layer are improved and an improved printing durability can be obtained.

As for the hydrophobic binder polymer, publicly known hydrophobic binder polymers preferably having a solubility in the above-described range can be used without limitation so long as the performance of the lithographic printing plate of the invention is not impaired thereby. Among all, a linear organic polymer having film-forming property is preferred.

Preferred examples of such a hydrophobic binder polymer include a polymer selected from acrylic resin, polyvinyl acetal resin, polyurethane resin, polyamide resin, epoxy resin, methacrylic resin, styrene-based resin and polyester resin. Among these, acrylic resin is preferred, and a (meth)acrylic acid ester copolymer is more preferred. More specifically, a copolymer of an alkyl or aralkyl ester of (meth) acrylic acid with a (meth)acrylic acid ester containing a -CH₂CH₂O- or - CH₂CH₂NH- unit in R of the ester residue (-COOR) of the (meth) acrylic acid ester is particularly preferred. The alkyl group in the (meth)acrylic acid alkyl ester is preferably an alkyl group having from 1 to 5 carbon atoms, more preferably a methyl group. Preferable examples of the (meth) acrylic acid aralkyl ester include benzyl (meth)acrylate.

The hydrophobic binder polymer may be made crosslinkable so as to enhance the film strength in the image area.

The crosslinkability may be imparted to the binder polymer by introducing a crosslinkable functional group such as an ethylenically unsaturated bond into the main chain or side chain of the polymer. The crosslinkable functional group may be introduced by either copolymerization or a polymer reaction.

The crosslinkable group as used herein means a group capable of crosslinking the polymer binder in the course of the radical polymerization which occurs in the photosensitive layer when the lithographic printing plate precursor is exposed. The crosslinkable group is not particularly restricted so long as having the above function. For example, there can be enumerated a functional group capable of undergoing addition polymerization such as an ethylenically unsaturated bond group, an amino group or an epoxy group. Alternatively, it may be a functional group capable of serving as a radical upon photoirradiation. Examples of a crosslinkable group of this type include a thiol group, a halogen group and an onium salt structure. Among these groups, an ethylenically unsaturated bond group is preferable and functional groups represented by the following formulae (1) to (3) are particularly preferred.

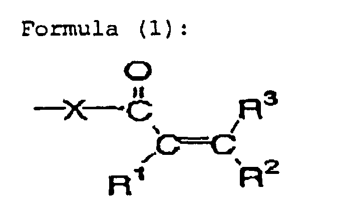

In the above formula (1), R¹ to R³ each independently represents a monovalent organic group. It is preferable that R¹ is a hydrogen atom or an alkyl group which may have a substituent. Among all, a hydrogen atom or a methyl group is preferred because of having a high radical reactivity. R² and R³ each independently represents a hydrogen atom, a halogen atom, an amino group, a carboxyl group, an alkoxycarbonyl group, a sulfo group, a nitro group, a cyano group, an alkyl group which may have a substituent, an aryl group which may have a substituent, an alkoxy group which may have a substituent, an aryloxy group which may have a substituent, an alkylamino group which may have a substituent, an arylamino group which may have a substituent, an alkylsulfonyl group which may have a substituent or an arylsulfonyl group which may have a substituent. Among all, a hydrogen atom, a carboxyl group, an alkoxycarbonyl group, an alkyl group which may have a substituent or an aryl group which may have a substituent is preferred because of having a high radical reactivity.

X represents an oxygen atom, a sulfur atom or N(R¹²)
wherein R¹² represents a hydrogen atom or a monovalent organic group. For example, R¹² represents an alkyl group which may have a substituent. Among all, a hydrogen atom, a methyl group, an ethyl group or an isopropyl group is preferred because of having a high radical reactivity.

Examples of the substituent which can be introduced therein include an alkyl group, an alkenyl group, an alkynyl group, an aryl group, an alkoxy group, an aryloxy group, a halogen atom, an amino group, an alkylamino group, an arylamino group, a carboxyl group, an alkoxycarbonyl group, a sulfo group, a nitro group, a cyano group, an amide group, an alkylsulfonyl group and an arylsulfonyl group.

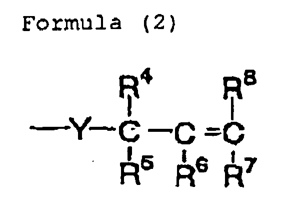

In the above formula (2), R⁴ to R⁸ each independently represents a monovalent organic group. It is preferable that R⁴ to R⁸ each independently represents a hydrogen atom, a halogen atom, an amino group, a dialkylamino group, a carboxyl group, an alkoxycarbonyl group, a sulfo group, a nitro group, a cyano group, an alkyl group which may have a substituent, an aryl group which may have a substituent, an alkoxy group which may have a substituent, an aryloxy group which may have a substituent, an alkylamino group which may have a substituent, an arylamino group which may have a substituent, an alkylsulfonyl group which may have a substituent or an arylsulfonyl group which may have a substituent. Among all, a hydrogen atom, a carboxyl group, an alkoxycarbonyl group, an alkyl group which may have a substituent or an aryl group which may have a substituent is preferred.

Examples of the substituent which can be introduced therein include the same ones as cited above with respect to the formula (1). Y represents an oxygen atom, a sulfur atom or N(R¹²) - wherein R¹² has the same meaning as R¹² in the formula (1) and preferable examples thereof are also the same.

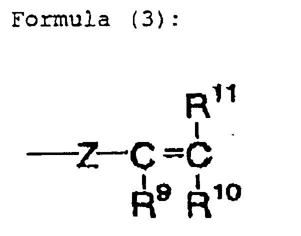

In the above formula (3), R⁹ preferably represents a hydrogen atom or an alkyl group which may have a substituent. Among all, a hydrogen atom or a methyl group is preferred because of having a high radical reactivity. R¹⁰ and R¹¹ each independently represents a hydrogen atom, a halogen atom, an amino group, a dialkylamino group, a carboxyl group, an alkoxycarbonyl group, a sulfo group, a nitro group, a cyano group, an alkyl group which may have a substituent, an aryl group which may have a substituent, an alkoxy group which may have a substituent, an aryloxy group which may have a substituent, an alkylamino group which may have a substituent, an arylamino group which may have a substituent, an alkylsulfonyl group which may have a substituent or an arylsulfonyl group which may have a substituent. Among all, a hydrogen atom, a carboxyl group, an alkoxycarbonyl group, an alkyl group which may have a substituent or an aryl group which may have a substituent is preferred because of having a high radical reactivity.

Examples of the substituent which can be introduced therein include the same ones as cited above with respect to the formula (1). Z represents an oxygen atom, a sulfur atom, N(R¹³)- or a phenylene group which may have a substituent. R¹³ represents an alkyl group which may have a substituent, etc. Among all, a methyl group, an ethyl group or an isopropyl group is preferred because of having a high radical reactivity.

Among those described above, a (meth)acrylic acid copolymer having a crosslinkable group in a side chain and polyurethane are still preferred.

In the crosslinkable hydrophobic binder polymer, for example, a free radical (a polymerization-initiating radical or a development radical in the course of the polymerization of a polymerizable compound) attaches to its crosslinkable functional group. Thus, polymerizable units undergo addition polymerization either directly or via chain polymerization of the polymerizable compound. As a result, a crosslinkage is formed among polymer molecules and the polymer is hardened. Alternatively, an atom in the polymer (for example, a hydrogen atom on a carbon atom adjacent to the functional crosslinkable group) is withdrawn by a free radical and a polymer radical is thus formed. Next, the polymer radicals are bonded together to form a crosslinkage among the polymer molecules, which results in hardening.

The content of the crosslinkable group (content of radical-polymerizable unsaturated double bond determined by iodine titration) in the hydrophobic binder polymer is preferably from 0.1 to 10.0 mmol, more preferably from 1.0 to 7.0 mmol, and most preferably from 2.0 to 5.5 mmol, per g of the hydrophobic binder polymer.

From the standpoint of enhancing the developability with an aqueous solution, the binder polymer is preferably hydrophilic. Also, from the standpoint of enhancing the printing durability, it is important that the binder polymer has good compatibility with the polymerizable compound contained in the photosensitive layer, that is, the binder polymer is preferably lipophilic. From this viewpoint, it is also effective in the invention to copolymerize a hydrophilic group and a lipophilic group in the hydrophobic binder polymer to thereby enhance the developability and the printing durability. Examples of the hydrophilic group which can be suitably used include those having a hydrophilic group such as a hydroxy group, a carboxylate group, a hydroxyethyl group, an ethyleneoxy group, a hydroxypropyl group, a polyoxyethyl group, a polyoxypropyl group, an amino group, an aminoethyl group, an aminopropyl group, an ammonium group, an amide group and a carboxymethyl group.

The hydrophobic binder polymer preferably has a weight-average molecular weight of 5,000 or more, more preferably from 10,000 to 300,000, and a number-average molecular weight of 1,000 or more, more preferably from 2,000 to 250,000. The polydispersity (weight-average molecular weight/number-average molecular weight) is preferably from 1.1 to 10.

The hydrophobic binder polymer may be a random polymer, a block polymer, a graft polymer or the like but is preferably a random polymer.

The hydrophobic binder polymers may be used either alone or in combination of two or more kinds thereof.

The content of the hydrophobic binder polymer is from 5 to 90 % by mass, preferably from 10 to 70 % by mass and more preferably from 10 to 60 % by mass, based on the total solid content of the photosensitive layer. Within this range, good strength of image area and good image-forming property can be obtained. (Polymerization initiator)

The polymerization initiator to be used in the invention is a compound which generates a radical when exposed to light or heat energy and thus initiates or accelerates polymerization of a compound having a polymerizable unsaturated group. As this radical generator, it is possible to select and use an appropriate compound from among known polymerization initiators and compounds having a bond with a small bond-dissociation energy.

Examples of the radical generator as described above include organohalogen compounds, carbonyl compounds, organic peroxides, azo-based polymerization initiators, azide compounds, metallocene compounds, hexaarylbiimidazole compounds, organoboron compounds, disulfone compounds, oxime ester compounds and onium salt compounds.

Specific examples of the organohalogen compound include the compounds described in Wakabayashi et al., Bull. Chem. Soc. Japan, 42, 2924 (1969), USP No. 3,905,815, JP-B-46-4605, JP-A-48-36281, JP-A-53-133428, JP-A-55-32070, JP-A-60-239736, JP-A-61-169835, JP-A-61-169837, JP-A-62-58241, JP-A-62-212401, JP-A-63-70243, JP-A-63-298339, and M. P. Hutt, Journal of Heterocyclic Chemistry, 1, No. 3 (1970) . Among these compounds, oxazole compounds substituted by a trihalomethyl group and s-triazine compounds are preferred.

Examples of the above-described carbonyl compound include benzophenone, Michler's ketone, 2-methylbenzophenone, 3-methylbenzophenone, 4-methylbenzophenone,
2-chlorobenzophenone and 4-bromobenzophenone.

As the above-described azo-based compound, use can be made of, for example, azo compounds described in JP-A-8-108621.

Examples of the above-described metallocene compound include various titanocene compounds described in JP-A-59-152396, JP-A-61-151197, JP-A-63-41484, JP-A-2-249, JP-A-2-4705 and JP-A-5-83588, and iron-allene complexes described in JP-A-1-152109.

Examples of the above-described hexaarylbiimidazole compound include various compounds described in JP-B-6-29285 and USP Nos. 3,479,185, 4,311,783 and 4,622,286.

Examples of the above-described organoboron compound include organic borates described in JP-A-2002-116539 and Martin Kunz, Rad Tech. '98. Proceeding, Apr. 19 to 22, 1998, Chicago; organic boron sulfonium complexes and organic boron oxosulfonium complexes described in JP-A-6-157623, JP-A-6-175564 and JP-A-6-175561; organic boron iodonium complexes described in JP-A-6-175554 and JP-A-6-175553; organic boron phosphonium complexes described in JP-A-9-188710; and organic boron transition metal coordination complexes described in JP-A-6-348011, JP-A-7-128785, JP-A-7-140589, JP-A-7-306527 and JP-A-7-292014.

Examples of the above-described disulfone compound include compounds described in JP-A-61-166544 and JP-A-2002-328465.

Examples of the above-described oxime ester compound include the compounds described in J.C.S. Perkin II, 1653 to 1660 (1979), J.C.S. Perkin II, 156 to 162 (1979), Journal of Photopolymer Science and Technology, 202 to 232 (1995) and JP-A-2000-66385 and the compounds described in JP-A-2000-80068.

Examples of the above-described onium salt compound include onium salts such as diazonium salts described in S. I. Schlesinger, Photogr. Sci. Eng., 18, 387 (1974) and T. S. Bal et al., Polymer, 21, 423 (1980); ammonium salts described in USP No. 4,069,055 and JP-A-4-365049; phosphonium salts described in USP Nos. 4,069,055 and 4, 069, 056; iodonium salts described in EP 104,143, USP Nos. 339,049 and 410,201, JP-A-2-150848 and JP-A-2-296514; sulfonium salts described in EPs 370,693, 390,214, 233,567, 297,443 and 297,442, USP Nos. 4,933,377, 161,811, 410,201, 339,049, 4,760,013, 4,734,444 and 2,833,827, and German Patents 2,904,626, 3,604,580 and 3,604,581; selenonium salts described in J. V. Crivello et al. , Macromolecules, 10 (6), 1307 (1977) and J. V. Crivello et al., J. Polymer Sci., Polymer Chem. Ed., 17, 1047 (1979); and arsonium salts described in C. S. Wen et al., Teh. Proc. Conf. Rad. Curing ASTA, p. 478 (Tokyo, October 1988).

In the invention, such an onium salt acts not as an acid generator but as an ionic radical generator.

Examples of the onium salt suitably usable in the invention are onium salts represented by the following formulae (RI-I) to (RI-III).

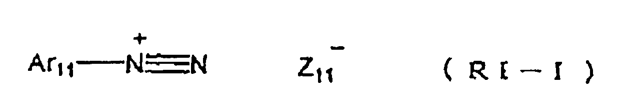

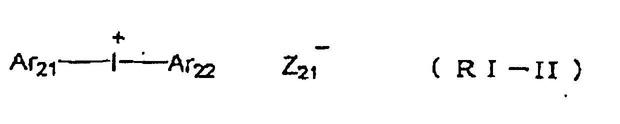

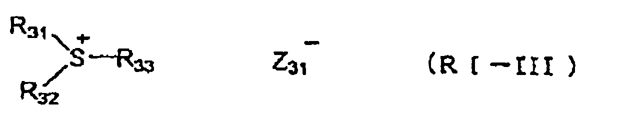

In the formula (RI-I), Ar₁₁ represents an aryl group having 20 or less carbon atoms, which may have from 1 to 6 substituent (s) . From the viewpoint of stability, perchlorate ion, hexafluorophosphate ion, tetrafluoroborate ion, sulfonate ion and sulfinate ion are particularly preferable.

In the formula (RI-II), Ar₂₁ and Ar₂₂ each independently represents an aryl group having 20 or less carbon atoms, which may have from 1 to 6 substituent(s). Preferable examples of the substituent include an alkyl group having from 1 to 12 carbon atoms, an alkenyl group having from 1 to 12 carbon atoms, an alkynyl group having from 1 to 12 carbon atoms, an aryl group having from 1 to 12 carbon atoms, an alkoxy group having from 1 to 12 carbon atoms, an aryloxy group having from 1 to 12 carbon atoms, a halogen atom, an alkylamino group having from 1 to 12 carbon atoms, a dialkylamino group having from 1 to 12 carbon atoms, an alkylamido or arylamido group having from 1 to 12 carbon atoms, a carbonyl group, a carboxyl group, a cyano group, a sulfonyl group, a thioalkyl group having from 1 to 12 carbon atoms, and a thioaryl group having from 1 to 12 carbon atoms. Z₂₁⁻ represents a monovalent anion. As specific examples thereof, perchlorate ion, hexafluorophosphate ion, tetrafluoroborate ion, sulfonate ion, sulfinate ion and carboxylate ion are preferable from the viewpoints of stability and reactivity.

In the formula (RI-III), R₃₁, R₃₂ and R₃₃ each independently represents an aryl, alkyl, alkenyl or alkynyl group having 20 or less carbon atoms, which may have from 1 to 6 substituent(s), and in view of reactivity and stability, preferably an aryl group. Z₃₁⁻ represents a monovalent anion. As specific examples thereof, perchlorate ion, hexafluorophosphate ion, tetrafluoroborate ion, sulfonate ion, sulfinate ion and carboxylate ion are preferable in view of stability and reactivity. As more preferable examples thereof, there can be enumerated carboxylate ion described in JP-A-2001-343742, and still more preferred is carboxylate ion described in JP-A-2002-148790.

Although the polymerization initiator is not limited to those described above, it is more preferable from the viewpoints of reactivity and stability to use a triazine-base initiator, an organohalogen compound, an oxime ester compound, a diazonium salt, an iodonium salt or a sulfonium salt.

Either one of these polymerization initiators or a combination of two or more kinds of the same may be used. These polymerization initiators may be added to a single layer together with other components. Alternatively, a separate layer may be formed for adding them. The polymerization initiator may be added in an amount of preferably from 0.1 to 50% by mass, more preferably from 0.5 to 30% by mass and particularly preferably from 0.8 to 20% by mass based on the total solid components constituting the photosensitive layer.

### (Infrared absorbing agent)

In the photosensitive layer of the lithographic printing plate precursor which is subjected to imagewise exposure using a light source radiating infrared light, use can be made of an infrared absorbing agent in combination with the polymerization initiator as described above. In general, an infrared absorbing agent has a function of converting absorbed infrared light into heat. Due to the heat thus generated, the polymerization initiator is thermally degraded to generate a radical. The infrared absorbing agent to be used in the invention is a dye or pigment having an absorption maximum in a wavelength range of 760 to 1200 nm.

As the dye, commercially available dyes and publicly known dyes described in literatures, for example, Senryo Binran (Dye Handbook) compiled by The Society of Synthetic Organic Chemistry, Japan (1970) can be utilized. Specific examples of the dye include azo dyes, metal complex azo dyes, pyrazolone azo dyes, naphthoquinone dyes, anthraquinone dyes, phthalocyanine dyes, carbonium dyes, quinoneimine dyes, methine dyes, cyanine dyes, squarylium dyestuffs, pyrylium salts and metal thiolate complexes.

Among these dyes, cyanine colorants, squarylium dyestuffs, pyrylium salts, nickel thiolate complexes and indolenine cyanine dyestuffs are particularly preferred.

Examples of the pigment usable in the invention include commercially available pigments and pigments described in Colour Index (C.I.), Saishin Ganryo Binran (Handbook of Newest Pigments) compiled by Pigment Technology Society of Japan (1977), Saishin Ganryo Oyo Gijutsu (Newest Application Technologies of Pigments), CMC Publishing Co., Ltd. (1986) and Insatsu Inki Gijutsu (Printing Ink Technology), CMC Publishing Co., Ltd. (1984).

Examples of the pigment include black pigments, yellow pigments, orange pigments, brown pigments, red pigments, purple pigments, blue pigments, green pigments, fluorescent pigments, metal powder pigments and polymer-bonded dyes. Specific examples of the pigment include insoluble azo pigments, azo lake pigments, condensed azo pigments, chelated azo pigments, phthalocyanine pigments, anthraquinone pigments, perylene and perynone pigments, thioindigo pigments, quinacridone pigments, dioxazine pigments, isoindolinone pigments, quinophthalone pigments, dying lake pigments, azine pigments, nitroso pigments, nitro pigments, natural pigments, fluorescent pigments, inorganic pigments and carbon black. Of the pigments, carbon black is preferred.

The particle size of the pigment is preferably in a range from 0.01 to 10 µm, more preferably in a range from 0.05 to 1 µm, and particularly preferably in a range from 0.1 to 1 µm. In the above-described range, good stability of the pigment dispersion in a coating solution for photosensitive layer and good uniformity of the photosensitive layer can be obtained.

It is preferred to add the infrared absorbing agent in the minimum necessary amount to the photosensitive layer in order to prevent a side effect of inhibiting the polymerization reaction.

The infrared absorbing agent can be added in an amount ordinarily from 0.001 to 50% by mass, preferably from 0.005 to 30% by mass, and particularly preferably from 0.01 to 10% by mass, based on the total solid content of the photosensitive layer. In the above-described range, the high sensitivity can be achieved without adversely affecting the uniformity and the film strength of the photosensitive layer. (Sensitizing dye)

In the photosensitive layer of the lithographic printing plate precursor which is subjected to imagewise exposure using a light source radiating light of 250 to 420 nm, use can be made of a sensitizing dye in combination with the polymerization initiator as described above to increase the radical generation efficiency.

Specific examples of the sensitizing dye include benzoin, benzoin methyl ether, benzoin ethyl ether, 9-fluorenone, 2-chloro-9-fluorenone, 2-methyl-9-fluorenone, 9-anthrone, 2-bromo-9-anthrone, 2-ethyl-9-anthrone, 9,10-anthraquinone, 2-ethyl-9,10-anthraquinone, 2-t-butyl-9,10-anthraquinone, 2,6-dichloro-9,10-anthraquinone, xantone, 2-methylxantone, 2-methoxyxantone, thioxantone, benzyl, dibenzalacetone, p-(dimethylamino)phenyl styryl ketone, p-(dimethylamino)phenyl p-methylstyryl ketone, benzophenone, p-(dimethylamino)benzophenone (or Michler's ketone), p-(diethylamino)benzophenone, benzanthrone and 2,5-bis(4-diethylaminophenyl)-1,3,4-oxadiazole.

The sensitizing dye can be added in an amount preferably from 0.1 to 50% by mass, more preferably from 0.5 to 30% by mass, and particularly preferably from 0.8 to 20% by mass, based on the total solid content of the photosensitive layer.

### (Polymerizable compound)

The polymerizable compound to be used in the photosensitive layer according to the invention is an addition-polymerizable compound having at least one ethylenically unsaturated double bond and it is selected from compounds having at least one, preferably two or more, terminal ethylenically unsaturated double bonds. Such compounds are broadly known in the field of art and they can be used in the invention without any particular limitation. The compound has a chemical form of, for example, a monomer, a prepolymer, specifically, a dimer, a trimer or an oligomer, or a mixture or a copolymer thereof. Examples of the monomer and copolymer thereof include unsaturated carboxylic acids (for example, acrylic acid, methacrylic acid, itaconic acid, crotonic acid, isocrotonic acid or maleic acid) and esters or amides thereof.

Preferably, esters of an unsaturated carboxylic acid with an aliphatic polyhydric alcohol compound and amides of an unsaturated carboxylic acid with an aliphatic polyvalent amine compound are used.

An addition reaction product of an unsaturated carboxylic acid ester or amide having a nucleophilic substituent, for example, a hydroxy group, an amino group or a mercapto group, with a monofunctional or polyfunctional isocyanate or epoxy, or a dehydration condensation reaction product of the unsaturated carboxylic acid ester or amide with a monofunctional or polyfunctional carboxylic acid is also preferably used. Furthermore, an addition reaction product of an unsaturated carboxylic acid ester or amide having an electrophilic substituent, for example, an isocyanato group or an epoxy group with a monofunctional or polyfunctional alcohol, amine or thiol, or a substitution reaction product of an unsaturated carboxylic acid ester or amide having a releasable substituent, for example, a halogen atom or a tosyloxy group with a monofunctional or polyfunctional alcohol, amine or thiol is also preferably used. In addition, compounds in which the unsaturated carboxylic acid described above is replaced by an unsaturated phosphonic acid, styrene, vinyl ether or the like can also be used. (Microcapsules)

As a method of adding the components constituting the photosensitive layer as described above and other components, which will be described hereinafter, to the photosensitive layer, it is possible in the invention that a part of the constituting components is encapsulated in microcapsules and then added to photosensitive layer as reported in JP-A-2001-277740 and JP-A-2001-27742. In this case, the individual constituting components may be contained inside and outside in the microcapsules at an arbitrary ratio.

A microcapsule wall preferably usable in the invention is one which has a three-dimensional crosslinkage structure and swells with a solvent. From these points of view, preferable examples of the microcapsule wall material include polyurea, polyurethane, polyester, polycarbonate, polyamide and a mixture thereof. Among all, polyurea and polyurethane are preferred. It is also possible to introduce a compound having a crosslinkable functional group such as an ethylenically unsaturated bond, which can be introduced into the water-insoluble polymer as discussed above, into the microcapsule wall.

The average particle diameter of the above-described microcapsules is preferably from 0.01 to 3.0 µm, more preferably from 0.05 to 2.0 µm and particularly preferably from 0.10 to 1.0 µm. Within this range, a favorable resolution and a high aging stability can be obtained.

### (Other components of photosensitive layer)

If necessary, the photosensitive layer of the invention may further contain various additives. Now, these additives will be illustrated.

### (Surfactant)

It is preferable in the invention to use a surfactant in the photosensitive layer to promote the developability and improve the coated face properties. As the surfactant, there can be enumerated a nonionic surfactant, an anionic surfactant, a cationic surfactant, an amphoteric surfactant and a fluorinated surfactant. Either a single surfactant or a combination of two or more kinds thereof may be used.

### (Hydrophilic polymer)

It is possible in the invention to add a hydrophilic polymer to improve the developability and elevate the dispersion stability of the microcapsules.

Suitable examples of the hydrophilic polymer include polymers having a hydrophilic group such as a hydroxy group, a carboxyl group, a carboxylate group, a hydroxyethyl group, a polyoxyethyl group, a hydroxypropyl group, a polyoxypropyl group, an amino group, an aminoethyl group, an aminopropyl group, an ammonium group, an amide group, a carboxymethyl group, a sulfonate group or a phosphate group.

The weight-average molecular weight of the hydrophilic polymer is preferably 5,000 or more and more preferably from 10,000 to 300,000. The hydrophilic polymer may be any one of a random polymer, a block polymer, a graft polymer and the like.

The content of the hydrophilic polymer in the photosensitive layer is preferably 20% by mass or less, more preferably 10% by mass or less, based on the total solid content in the photosensitive layer. (Colorant)

In the invention, a dye having a large absorption within the visible light range can be used as an image colorant. Specific examples of the dye include Oil Yellow #101, Oil Yellow #103, Oil Pink #312, Oil Green BG, Oil Blue BOS, Oil Blue #603, Oil Black BY, Oil Black BS, Oil Black T-505 (manufactured by Orient Chemical Industries, Ltd.), Victoria Pure Blue, Crystal Violet (CI42555), Methyl Violet (CI42535), Ethyl Violet, Rhodamine B (CI145170B), Malachite Green (CI42000), Methylene Blue (CI52015), and dyes which are disclosed in JP-A-62-293247. Further, dyes such as phthalocyanine-based dye, azo-based dye, carbon black and titanium oxide are preferably usable.

It is preferable to add these colorants so as to make an image area distinguishable from a non-image area after the image formation. The amount of these colorants to be incorporated in the image forming layer is preferably from 0.01 to 10% by mass based on the total solid content in the image-recording material.

### (Printing Agent)

In order to form a printed-out image, the photosensitive layer of the invention may contain a compound which changes its color when exposed to an acid or a radical. Examples of such a compound advantageously usable herein include various dyestuffs such as diphenylmethane-based dyestuffs, triphenylmethane-based dyestuffs, thiazine-based dyestuffs, oxazine-based dyestuffs, xanthene-based dyestuffs, anthraquinone-based dyestuffs, iminoquinone-based dyestuffs, azo-based dyestuffs and azomethine-based dyestuffs.

The amount of each dye which changes its color when exposed to an acid or a radical is from 0.01 to 15% by mass based on the solid content of the photosensitive layer.

### (Polymerization inhibitor)

The photosensitive layer of the invention preferably contains a small amount of a heat polymerization inhibitor to inhibit unnecessary heat polymerization of radical-polymerizable compounds during the production or storage of the photosensitive layer.

Preferable examples of the heat polymerization inhibitor usable herein include hydroquinone, p-methoxyphenol, di-t-butyl-p-cresol, pyrogallol, t-butyl catechol, benzoquinone, 4,4'-thiobis(3-methyl-6-t-butylphenol), 2,2'-methylenebis(4-methyl-6-t-butylphenol) and N-nitroso-N-phenylhydroxylamine aluminum salt.

The amount of the heat polymerization inhibitor to be added is preferably from about 0.01 to about 5% by mass based on the total solid content of the photosensitive layer.

### (Higher fatty acid derivative)

The photosensitive layer of the invention may contain a higher fatty acid derivative such as behenic acid or behenic acid amide so that it is localized on the surface of the photosensitive layer during drying following coating to prevent the inhibition of polymerization by oxygen. The amount of the higher fatty acid derivative to be added is preferably from about 0.1 to about 10% by mass based on the total solid content of the photosensitive layer.

### (Plasticizer)

The photosensitive layer of the invention may comprise a plasticizer. Preferable examples of the plasticizer usable herein include phthalic acid esters such as dimethyl phthalate, diethyl phthalate, dibutyl phthalate, diisobutyl phthalate, dioctyl phthalate, octylcapryl phthalate, dicyclohexyl phthalate, ditridecyl phthalate, butylbenzyl phthalate, diisodecyl phthalate and diallyl phthalate; glycol esters such as dimethyl glycol phthalate, ethylphthalylethyl glycolate, methylphthalylethyl glycolate, butylphthalylbutyl glycolate and triethyleneglycol dicaprylic acid ester; phosphoric acid esters such as tricresyl phosphate and triphenyl phosphate; aliphatic dibasic acid esters such as diisobutyl adipate, dioctyl adipate, dimethyl sebacate, dibutyl sebacate, dioctyl azelate and dibutyl maleate; polyglycidyl methacrylate, triethyl citrate, glycerintriacetyl ester and butyl laurate. The content of the plasticizer is preferably about 30% by mass or less based on the total solid content of the photosensitive layer. (Inorganic microparticles)

The photosensitive layer of the invention may comprise inorganic microparticles to enhance the strength of the hardened film in an image area. Preferable examples of the inorganic microparticles usable herein include those made of silica, alumina, magnesium oxide, titanium oxide, magnesium carbonate, calcium alginate or a mixture thereof. These inorganic microparticles may be used to reinforce the film and elevate the interfacial adhesiveness after surface roughening even if they are not capable of converting light to heat. The inorganic microparticles preferably have an average particle diameter of from 5 nm to 10 µm, more preferably from 0.5 µm to 3 µm. Within this range, the inorganic microparticles can be dispersed in the photosensitive layer in a stable manner to keep the strength of the photosensitive layer sufficiently high, making it possible to form a non-image area having an excellent hydrophilicity which suffers from little stain during printing.

The inorganic microparticles as described above can be easily available as a commercial product such as a colloidal silica dispersion.

The content of the inorganic microparticles is preferably 20% by mass or less, more preferably 10% by mass or less based on the total solid content of the photosensitive layer.

### (Low molecular hydrophilic compound)

The photosensitive layer of the invention may contain a hydrophilic low molecular compound to enhance the developability thereof. Examples of the hydrophilic low molecular compound usable herein include water-soluble organic compounds such as glycol (for example, ethylene glycol, diethylene glycol, triethylene glycol, propylene glycol, dipropylene glycol, tripropylene glycol) and ether or ester derivatives thereof, polyhydroxy compounds (for example, glycerin, pentaerythritol), organic amines (for example, triethanolamine, diethanolamine, monoethanolamine) and salts thereof, organic sulfonic acids (for example, toluenesulfonic acid, benzenesulfonic acid) and salts thereof, organic phosphonic acids (for example, phenylphosphonic acid) and salts thereof, organic carboxylic acids (for example, tartaric acid, oxalic acid, citric acid, malic acid, lactic acid, gluconic acid, amino acids) and salts thereof, and organic quaternary ammonium salts (for example, tetraethylamine hydrochloride).

In addition to the components as described above, the photosensitive layer of the invention may contain, for example, a cosensitizer.

### <Formation of photosensitive layer>

The photosensitive layer of the invention is formed by preparing a coating solution by dispersing or dissolving the above-described necessary components in a solvent and then coating the same. Examples of the solvent usable herein include ethylene dichloride, cyclohexanone, methyl ethyl ketone, methanol, ethanol, propanol, ethylene glycol monomethyl ether, 1-methoxy-2-propanol, 2-methoxyethyl acetate, 1-methoxy-2-propyl acetate, dimethoxyethane, methyl lactate, ethyl lactate, N,N-dimethylacetamide, N,N-dimethylformamide, tetramethylurea, N-methylpyrrolidone, dimethyl sulfoxide, sulfolane, γ-butyl lactone, toluene, and water, though the invention is not limited to these solvents. Either a single solvent or a mixture thereof may be used. The solid concentration of the coating solution is preferably from 1 to 50% by mass.

It is also possible to form the photosensitive layer of the invention by preparing a plurality of coating solutions having the same or different components selected from the above-described ones dispersed or dissolved in the same or different solvents, and then repeatedly coating and drying.

Although the photosensitive layer coating amount (solid content) on the support obtained after coating and drying varies depending on the purpose, it is preferably from 0.3 to 3.0 g/m². Within this range, a good sensitivity and favorable film properties of the photosensitive layer can be achieved.

The coating may be conducted by various methods.
Examples of the coating method usable herein include the bar coating method, the rotary coating method, the spray coating method, the curtain coating method, the dip coating method, the air knife coating method, the blade coating method and the roll coating method.

### <Protective layer>

To such a radical polymerizable photosensitive layer, it is particularly necessary to provide a protective layer for blocking oxygen that inhibits the polymerization. The protective layer is dissolved in the developer and thus increases the developer viscosity, which is effective in the automatic developing machine according to the invention. In the lithographic printing plate precursor of the invention, it is preferable to form a protective layer (an oxygen block layer) on the photosensitive layer to prevent the diffusion and invasion of oxygen which inhibits the polymerization at exposure. The protective layer to be used in the invention preferably has a low oxygen transmission rate A, i.e., 1.0≤A≤20 (mL/m² day) at 25°C under one atom. When the oxygen transmission rate A is extremely low, i.e., less than 1.0 (mL/m² day), there arise some problems such that unnecessary polymerization occurs during manufacturing or storage or unnecessary fogging or line thickening occurs at image exposure. When the oxygen transmission rate A is excessively high, i.e., more than 20 (mL/m² day), on the other hand, the sensitivity is lowered. More preferably, the oxygen transmission rate falls within the range 1.5≤A≤12 (mL/m² day) , more preferably 2.0≤A≤10.0 (mL/m² day) . In addition to the oxygen transmission rate as discussed above, it is desirable that the protective layer does not substantially inhibit the transmission of light to be used in exposure, shows an excellent adhesion to the photosensitive layer and can be easily removed in the development step after exposure. Various studies have been made on such a protective layer as having these properties. For the details of these studies, reference can be made to USP No. 3,458,311 and JP-B-55-49729.

As the material usable in the protective layer, it is preferable to use a water-soluble high molecule compound having a relatively excellent crystallinity. Specific examples thereof usable herein include water-soluble polymers such as polyvinyl alcohol, vinyl alcohol/vinyl phthalate copolymer, vinyl acetate/vinyl alcohol/vinyl phthalate copolymer, vinyl acetate/crotonic acid copolymer, polyvinylpyrrolidone, acidic cellulose, gelatin, gum arabic, polyacrylic acid and polyacrylamide. Either one of these compounds or a mixture thereof may be used. Among all, use of polyvinyl alcohol as the main component makes it possible to give the best results with respect to basic properties such as oxygen barrier properties and development removability.

It is also preferred that the protective layer of the lithographic printing plate precursor of the invention contains an inorganic stratiform compound to improve oxygen barrier properties and protective effect on the photosensitive layer surface.

The inorganic stratiform compound is a particle having a thin tabular shape. The stratiform compound includes, for example, mica materials such as natural mica represented by the following formula:
A (B, C) ₂₋₅ D₄ O₁₀ (OH, F, O)₂
(wherein A represents any one of K, Na and Ca; B and C each represents any one of Fe (II), Fe(III), Mn, Al, Mg and V; and D represents Si or Al) or synthetic mica; talc represented by the following formula: 3MgO·4SiO·H₂O; teniolite; montmorillonite; saponite; hectolite; and zirconium phosphate.

Examples of the natural mica include muscovite, paragonite, phlogopite, biotite and lepidolite. Examples of the synthetic mica include non-swellable mica such as fluorine phlogopite KMg₃ (AlSi₃O₁₀) F₂ or potassium tetrasilic mica KMg_{2.5} (Si₄O₁₀) F₂, and swellable mica such as Na tetrasililic mica NaMg_{2.5} (Si₄O₁₀) F₂ , Na or Li teniolite (Na, Li) M_{g2}Li (Si₄O₁₀) F₂, or montmorillonite based Na or Li hectolite (Na, Li)_{1/8}Mg_{2/5} Li)_{1/8}(Si₄O₁₀)F₂. Synthetic smectite is also useful.

With respect to the particle size of the inorganic stratiform compound used in the invention, an average major diameter is ordinarily from 0.3 to 20 µm, preferably from 0.5 to 10 µm, and particularly preferably from 1 to 5 µm. An average thickness of the particle is ordinarily 0.1 µm or less, preferably 0.05 µm or less, and particularly preferably 0.01 µm or less. For example, the swellable synthetic mica that is the typical compound of the inorganic stratiform compounds has a thickness of approximately from 1 to 50 nm and a plane size of approximately from 1 to 20 µm.

The thus prepared coating solution for protective layer is coated on the photosensitive layer provided on a support and dried to form a protective layer. A coating solvent can be appropriately selected by considering the relationship with the binder employed. When a water-soluble polymer is used, it is preferred to employ distilled water or purified water as the coating solvent. A coating method of the protective layer is not particularly restricted and publicly known methods such as methods described in USP No. 3,458,311 and JP-B-55-49729 can be used. More specifically speaking, the protective layer is coated by, for example, the blade coating method, the air knife coating method, the gravure coating method, the roll coating method, the spray coating method, the dip coating method or the bar coating method.

The coating amount of the protective layer is preferably from 0.05 to 10 g/m². In the case of containing an inorganic stratiform compound, it is more preferable that the coating amount is from 0.1 to 0.5 g/m² In the case of not containing an inorganic stratiform compound, it is more preferable that the coating amount is from 0.5 to 5 g/m².

### <Support>

The support to be used in the lithographic printing plate precursor according to the invention is not particularly restricted so long as it is a dimensionally stable plate-like hydrophilic material. For example, use can be made of paper, plastic, paper laminated with plastic (for example, polyethylene, polypropylene or polystyrene), a metal plate (for example, an aluminum, zinc or copper plate), a plastic film (for example, a cellulose diacetate, cellulose triacetate, cellulose propionate, cellulose butyrate, cellulose acetatebutyrate, cellulose nitrate, polyethylene terephthalate, polyethylene, polystyrene, polypropylene, polycarbonate or polyvinyl acetal film) and paper or a plastic film laminated or deposited with the metal described above. Preferable examples of the support include, a polyester film and an aluminum plate. Among them, the aluminum plate is preferred because of having a good dimensional stability and being relatively inexpensive.

The thickness of the support is preferably from 0.1 to 0.6 mm, more preferably from 0.15 to 0.4 mm and particularly preferably from 0.2 to 0.3 mm.

A surface roughening treatment of the surface of the aluminum plate is conducted by various methods, for example, a mechanical roughening treatment, an electrochemical roughening treatment (a roughening treatment of electrochemically dissolving the surface) and a chemical roughening treatment (roughening treatment of chemically dissolving the surface selectively).

As the method of the mechanical roughening treatment, use can be made of a publicly known method such as the ball grinding method, the brush grinding method, the blast grinding method or the buff grinding method.

Examples of the electrochemical roughening treatment method include a method wherein the aluminum plate is treated with an alternating current or a direct current in an electrolyte containing an acid such as hydrochloric acid or nitric acid. Also, a method of using a mixed acid as described in JP-A-54-63902 can be used therefor.

The surface-roughened aluminum plate is then subjected, if desired, to an alkali etching treatment using an aqueous solution of, for example, potassium hydroxide or sodium hydroxide. After further performing a neutralizing treatment, the aluminum plate is subjected to an anodic oxidation treatment to thereby increase the abrasion resistance, if desired.

As the electrolyte to be used in the anodic oxidation treatment of the aluminum plate, various electrolytes capable of forming a porous oxide film can be used. In usual, sulfuric acid, hydrochloric acid, oxalic acid, chromic acid or a mixed acid thereof is used. The concentration of the electrolyte can be appropriately determined depending on the kind of the electrolyte.

Since the conditions for the anodic oxidation treatment vary depending on the electrolyte employed, they cannot be defined commonly. However, it is usually preferred that the electrolyte concentration of the solution is from 1 to 80% by mass, the liquid temperature is from 5 to 70°C, the current density is from 5 to 60 A/dm², the voltage is from 1 to 100 V, and the electrolysis time is from 10 seconds to 5 minutes. The amount of the anodically oxidized film formed is preferably from 1. 0 to 5. 0 g/m² and more preferably from 1. 5 to 4.0 g/m². Within this range, a high printing durability and a high scratch resistance in an non-image area of the lithographic printing plate can be achieved.

As the support to be used in the invention, the aluminum plate having been subjected to the surface treatment and having the anodically oxidized film may be used as such. However, in order to more improve the adhesion to a layer provided thereon, hydrophilisity, resistance to stain, heat insulating properties or the like, it is possible to perform an appropriate additional treatment selected from among, for example, a treatment for enlarging micropores or a sealing treatment of micropores of the anodically oxidized film as described in JP-A-2001-253181 and JP-A-2001-322365, and a surface hydrophilizing treatment by immersing in an aqueous solution containing a hydrophilic compound. Needless to say, the enlarging treatment and sealing treatment of micropores are not limited to those described in the above documents and any publicly known method may be employed therefor.

As the hydrophilicization treatment, use can be made of the alkaline metal silicate method as disclosed in USP Nos. 2,714,066, 3,181,461, 3,280,734 and 3,902,734. This method comprises dipping or electrolyzing the support in an aqueous solution of sodium silicate or the like. Other examples of the hydrophilicization treatment usable herein include the method comprising the treatment with potassium zirconate fluoride as disclosed in JP-B-36-22063, and the method comprising the treatment with a polyvinylphosphonic acid as disclosed in USP Nos. 3,276,868, 4,153,461 and 4,689,272.

### <Undercoat Layer>

It is preferable that the lithographic printing plate precursor of the invention has an undercoat layer, which contains a compound having a polymerizable group, on the support. In the case of using the undercoat layer, the photosensitive layer is provided on the undercoat layer. In an exposed area, the undercoat layer strengthens the adhesion between the support and the photosensitive layer. In an unexposed area, the undercoat layer facilitates the peeling of the photosensitive layer from the support, thereby improving the developability.

Preferred examples of the undercoat layer usable herein include a silane coupling agent having an addition-polymerizable ethylenically double bond reactive group as disclosed in JP-A-10-282679, and phosphorus compounds having an ethylenically double bond reactive group as disclosed in JP-A-2-304441. Particularly preferable compounds include those having a polymerizable group such as a methacryl group or an acryl group and a support-adsorptive group such as a sulfonate group, a phosphate group or a phosphoric ester. Moreover, compounds having a hydrophilicity-imparting group such as an ethylene oxide group together with the polymerizable group and the support-adsorptive group can be cited as preferable compounds.

The coating amount (solid content) of the undercoat layer is preferably from 0.1 to 100 mg/m², more preferably from 1 to 30 mg/m².

### <Backcoat Layer>

After subjecting the support to the surface treatment or forming the undercoat layer thereon, a backcoat layer may be formed on the back side of the support, if necessary.

Preferred examples of the backcoat layer usable herein include a layer made of an organic polymer compound as disclosed in JP-A-5-45885, and a layer made of a metal oxide obtained by the hydrolysis or polycondensation of an organic metal compound or inorganic metal compound as disclosed in JP-A-6-35174. In particular, it is preferred to use silicon alkoxy compounds such as Si (OCH₃)₄, Si(OC₂H₅)₄, Si(OC₃H₇)₄ and Si (OC₄H₉) ₄ from the viewpoints of being inexpensive and easily available.

On the front face of the photosensitive layer or overcoat layer thus formed, a matting layer is formed to shorten the time required for evacuation in contact exposure using a vacuum printing frame and for prevent lack of sharpness in printing. The matting layer can be formed by the method, for example, described in JP-A-50-125805, JP-B-57-6582 and JP-B-61-28986 or by thermally fusing a solid powder as described in JP-B-62-62337.

Then, the light-condensing lithographic printing plate precursor thus obtained is exposed through a transparent original by using active rays radiated from a light source such as a carbon arc lamp, a mercury lamp, a metal halide lamp, a xenon lamp or a tungsten lamp, or directly exposed to an Ar laser, a YAG-SHG laser, a violet laser or an infrared laser, followed by the development.

Next, a specific example of the developer D and a specific example of the lithographic printing plate S will be presented. Specific example of developer D:
(A) Aqueous solution 1 is prepared. In the following composition, each amount is expressed in [g]. The aqueous solution 1 has a pH value of 4.3.

| | |
|---|---|
| Water | 8970 g |
| Anionic surfactant (following chemical formula) | 400 g |
| 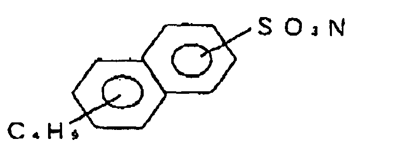 | |
| Gum arabic | 150 g |
| Enzymatically modified potato starch | 400 g |
| Na salt of dioctylsulfosuccinic acid ester | 50 g |
| Ammonium primary phosphate | 10 g |
| Citric acid | 10 g |
| EDTA-4-Na salt | 10 g |
| pH 4.3 | |

### Specific example of lithographic printing plate S:

### Production of support:

An aluminum plate (material: 1050) having a thickness of 0.3 mm is subjected to a degrease treatment with a 10% by mass aqueous sodium aluminate solution at 50°C for 30 seconds to thereby remove rolling oil on the surface thereof. Thereafter, the aluminum plate surface is sand grained by using three nylon brushes implanted with bundled bristles having a diameter of 0.3 mm and an aqueous suspension (specific gravity: 1.1 g/cm³) of pumice having a median diameter of 25 µm, and then thoroughly wshed with water. The plate is etched by dipping it in an 25% by mass aqueous sodium hydroxide solution at 45°C for 9 seconds and, after washing with water, dipped in a 20% by mass aqueous nitric acid solution at 60°C for 20 seconds, followed by wshing with water. The etching amount of the sand grained surface is about 3 g/m².

Subsequently, the aluminum plate is subjected to a continuous electrochemical surface roughening treatment using alternate current voltage of 60 Hz.

The electrolytic solution used is a 1% by mass aqueous nitric acid solution (containing 0.5% by mass of aluminum ion) at a liquid temperature of 50°C. The electrochemical surface roughening treatment is performed using a rectangular wave alternate current having a trapezoidal waveform such that the time TP necessary for the current value to reach the peak from zero is 0.8 msec and the duty ratio is 1:1, and disposing a carbon electrode as the counter electrode. The auxiliary anode used is ferrite.

The current density is 30 A/dm² expressed in the peak value of current, and 5% of the current flowing from the power source is divided to the auxiliary anode. The quantity of electricity at the nitric acid electrolysis is 175 C/dm² when the aluminum plate is serving as the anode.

Subsequently, the aluminum plate is washed with water by spraying.

Next, the aluminum plate is subjected to an electrochemical surface roughening treatment in the same manner as in the nitric acid electrolysis as described above by using, as the electrolytic solution, a 0.5% by mass aqueous hydrochloric acid solution (containing 0.5% by mass of aluminum ion) at a liquid temperature of 50°C under the conditions that the quantity of electricity is 50 C/dm² when the aluminum plate is serving as the anode, and then washed with water by spraying.

The plate is then treated in a 15% by mass aqueous sulfuric acid solution (containing 0.5% by mass of aluminum ion) as the electrolytic solution at a current density of 15 A/dm² to provide a direct current anodic oxide film of 2.5 g/m², followed by washing with water drying.

The center line average roughness (Ra) of the thus-treated aluminum plate that is measured with a stylus having a diameter of 2 µm is 0.51 µm.

Further, an undercoat solution (1) shown below is coated to give a dry coating amount of 10 mg/m² to prepare a support to be used in the subsequent experiment.
Undercoat solution (I)
- Undercoat compound (1) 0.017 g
- Methanol 9.00 g
- Water 1.00 g
   Undercoat compound (1):

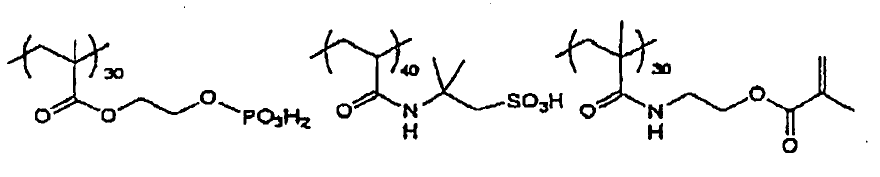

On the support having the undercoat layer prepared above, coating solution (1) for photosensitive layer having the following composition is bar-coated and dried in an oven at 70°C for 60 seconds to form an image-recording layer having a dry coating amount of 1.1 g/m². On this layer, coating solution (1) for protective layer having the following composition is bar-coated to give a dry coating amount of 0.75 g/m² and dried at 125°C for 70 seconds to thereby prepare a lithographic printing plate precursor.

### <Coating solution (1) for photosensitive layer>

- Binder Polymer shown below 0.54 g (weight-average molecular weight 80,000)
- Polymerizable compound (iocyanuric acid EO- 0.40 g denatured triacrylate) (ARONIX M-315, manufactured by TOAGOSEI Co., Ltd.)
- Polymerizable compound (ethoxylated trimethylol- 0.08 g propane triacrylate; SR9035, added EO moles: 15, molecular weight 1000; manufactured by NIPPON KAYAKU Co., Ltd.)
- Sensitizing dye (1) shown below 0.06 g
- Polymerization Initiator (2) 0.18 g shown below
- Chain transfer agent (1) shown below 0.07 g
- ε-phthalocyanine pigment dispersion 0.40 g (pigment: 15 parts by mass, dispersant binder polymer (1): 10 parts by mass, solvent:cyclohexane/methoxypropyl acetate/1-methoxy-2-propanol=15 parts by mass/20 parts by mass/40 parts by mass)
- Heat polymerization inhibitor 0.01 g N-introsphenylhydrxylamine aluminum salt
- Water-soluble fluorinated surfactant (1) 0.001 g shown below
- Polyoxyethylene-polyoxypropylene condensate 0.04 g (Pluronic L44, manufactured by ADEKA Co.)
- Tetraethylamine hydrochloride 0.01 g
- 1-Methoxy-2-propanol 3.5 g
- Methyl ethyl ketone 8.0 g
   Binder polymer (1): 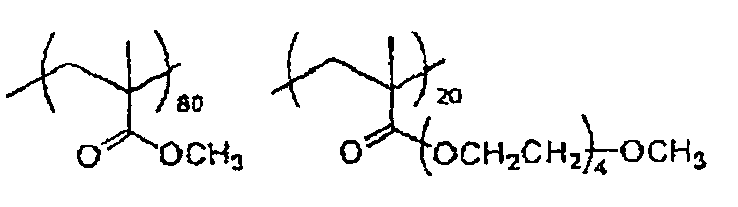 Sensitizing Dye (1): 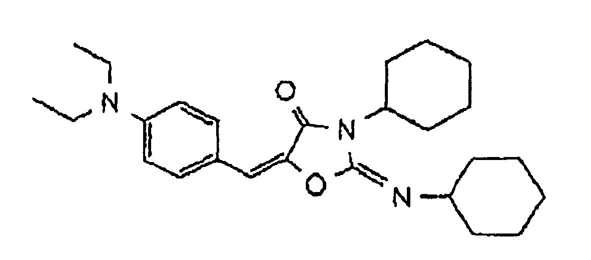 Polymerization Initiator (2): 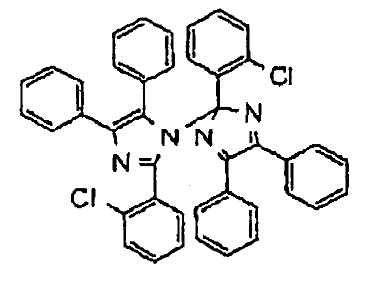 Chain Transfer Agent (1): 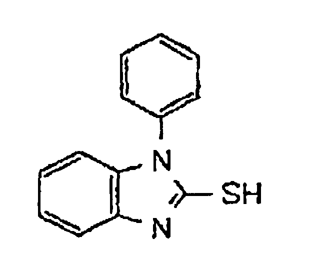 Fluorinated surfactant (1):

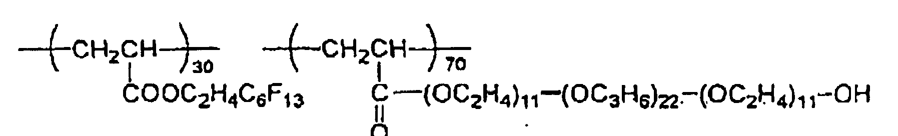

Coating solution (1) for protective layer
- Polyvinyl alcohol (degree of saponification 40 g 98% by mol, degree of polymerization 500)
- Polyvinylpyrrolidone (weight-average 5 g molecular weight 50,000)
- Poly(vinylpyrrolidone/vinyl acetate (1/1)) 0.5 g (weight-average molecular weight 70,000)
- Surfactant (EMALEX 710, manufactured by Nihon- 0.5 g
   Emulsion Co., Ltd.)
- Water 950 g

The method for developing a lithographic printing plate according to the ivnention is not restricted to the embodiments as described above and appropriate changes, modifications, etc. can be made.

## Claims

1. A method for developing a lithographic printing plate comprising treating a lithographic printing plate (s), while conveying the plate, at least in a pre-heating zone (20) and a development zone (40) located downstream thereof in a developing apparatus (1);
wherein:
the development zone comprises a treating tank (42), which contains a developer (D), and a developer-circulating unit (76, 146), the developer-circulating unit being located in the neighbourhood of the plate inlet of the treating tank, which is a region located above a guide board (48) between the plate inlet and first rollers (52) located in the developer along the plate-conveyance route, the guide board being located in the developer between the plate inlet and the first rollers;
developer in the neighbourhood of the plate inlet is conveyed and circulated in the treating tank by the developer-circulating unit; and
the developer-circulating unit is one of the following:
(i) a tubular spray pipe (142) extending along the axial direction of the first rollers, which are conveying rollers, and having multiple ports along its length which discharge fresh developer in the radial direction of the first rollers towards developer pooled at the upstream side of the first rollers;
(ii) a rotating blade member (146) which extends along the axial direction of the first rollers, which are conveying
rollers, and causes developer in the neighbourhood of the plate inlet to flow and be replaced by developer under circulation in the treating tank.

2. A method according to Claim 1, wherein the rotating blade member (146) generates a flow of developer by rotation and vibration.

3. A method according to Claim 1 or Claim 2, wherein at least the development zone (40) has an enclosed structure.

4. A method according to any preceding claim, wherein the developer comprises from 3 to 20% by mass of a surfactant and has a pH of from 4 to 9.5.

5. A method according to Claim 4, wherein the developer further comprises from 1 to 10% by mass of a water-soluble resin.

## Patentansprüche

1. Verfahren zum Entwickeln einer Lithografiedruckplatte, umfassend das Behandeln einer Lithografiedruckplatte (S), während die Platte befördert wird, in zumindest einer Vorheizzone (20) und einer dieser nachgeschalteten Entwicklungszone (40) in einer Entwicklungsvorrichtung (1);
worin:
die Entwicklungszone einen Behandlungstank (42), der einen Entwickler (D) enthält, und eine Entwickler-Zirkulationseinheit (76, 146) umfasst, worin die Entwickler-Zirkulationseinheit in Nachbarschaft zum Platteneinlass des Behandlungstanks lokalisiert ist, welche ein Bereich ist, der oberhalb einer Führungsplatte (48) zwischen dem Platteneinlass und ersten Rollen (52) lokalisiert ist, die in dem Entwickler entlang des Platten-Beförderungswegs lokalisiert sind, wobei die Führungsplatte in dem Entwickler zwischen dem Platteneinlass und den ersten Rollen lokalisiert ist;
der Entwickler in der Nachbarschaft des Platteneinlasses durch die Entwickler-Zirkulationseinheit befördert und in dem Behandlungstank zirkuliert wird; und
die Entwickler-Zirkulationseinheit eine der folgenden ist:
(i) ein röhrenförmiges Sprührohr (142), das sich entlang der axialen Richtung der ersten Rollen erstreckt, welche Beförderungsrollen sind, und welches mehrere Auslässe entlang seiner Länge aufweist, die frischen Entwickler in Radialrichtung der ersten Rollen hin zu Entwickler, der an der vorgeschalteten Seite der ersten Rollen gesammelt wird, ausstoßen;
(ii) ein rotierendes Klingenbauteil (146), welches sich entlang der axialen Richtung der ersten Rollen erstreckt, die Beförderungsrollen sind, und welches verursacht, dass Entwickler in der Nachbarschaft des Platteneinlasses fließt und durch Entwickler unter Zirkulation in dem Behandlungstank ersetzt wird.

2. Verfahren gemäß Anspruch 1, worin das rotierende Klingenbauteil (146) einen Entwicklerfluss durch Rotation und Vibration generiert.

3. Verfahren gemäß Anspruch 1 oder Anspruch 2, worin mindestens die Entwicklungszone (40) eine abgeschlossene Struktur aufweist.

4. Verfahren gemäß irgendeinem vorhergehenden Anspruch, worin der Entwickler von 3 bis 20 Masse% eines Tensids umfasst und einen pH-Wert von 4 bis 9,5 aufweist.

5. Verfahren gemäß Anspruch 4, worin der Entwickler ferner 1 bis 10 Masse% eines wasserlöslichen Harzes umfasst.

## Revendications

1. Procédé pour développer une plaque d'impression lithographique comprenant le traitement d'une plaque d'impression lithographique (S), tout en transportant la plaque, au moins dans une zone de préchauffage (20) et une zone de développement (40) située en aval de celle-ci dans un appareil de développement (1) ;
dans lequel :
la zone de développement comprend un réservoir de traitement (42), qui contient un révélateur (D), et une unité de circulation de révélateur (76, 146), l'unité de circulation de révélateur étant située à proximité de l'entrée de plaque du réservoir de traitement, qui est une région située au-dessus d'un tableau de guidage (48) entre l'entrée de plaque et des premiers rouleaux (52) situés dans le révélateur le long de la route de transport d'une plaque, le tableau de guidage étant situé dans le révélateur entre l'entrée de plaque et les premiers rouleaux ;
révélateur à proximité de l'entrée de plaque est transporté et circulé dans le réservoir de traitement par l'unité de circulation de révélateur ; et
l'unité de circulation de révélateur est l'une des suivantes :
(i) un tuyau de pulvérisation tubulaire (142) s'étendant le long de la direction axiale des premiers rouleaux, qui sont des rouleaux de transport, et ayant des ports multiples le long de sa longueur qui déversent du révélateur frais dans la direction radiale des premiers rouleaux vers du révélateur concentré du côté en amont des premiers rouleaux ;
(ii) un élément à lame rotative (146) qui s'étend le long de la direction axiale des premiers rouleaux, qui sont des rouleaux de transport, et amène le révélateur à proximité de l'entrée de plaque à couler et être remplacé par du révélateur en circulation dans le réservoir de traitement.

2. Procédé selon la revendication 1, dans lequel l'élément à lame rotative (146) génère un flux de révélateur par rotation et vibration.

3. Procédé selon la revendication 1 ou la revendication 2, dans lequel au moins la zone de développement (40) a une structure close.

4. Procédé selon l'une quelconque des revendications précédentes, dans lequel le révélateur comprend de 3 à 20% en masse d'un surfactant et a un pH de 4 à 9,5.

5. Procédé selon la revendication 4, dans lequel le révélateur comprend en outre de 1 à 10% en masse d'une résine hydrosoluble.
